(19) Europäisches Patentamt
European Patent Office
Office européen des brevets

(11) **EP 4 219 639 A1**

(12) **EUROPEAN PATENT APPLICATION**

(43) Date of publication:
**02.08.2023   Bulletin 2023/31**

(21) Application number: **22154643.5**

(22) Date of filing: **01.02.2022**

(51) International Patent Classification (IPC):
**C09D 127/08** (2006.01)      **C09D 127/16** (2006.01)
**C09D 7/20** (2018.01)      **C08L 27/16** (2006.01)
**H01L 41/45** (2013.01)

(52) Cooperative Patent Classification (CPC):
(C-Sets available)
**C09D 5/24; C08F 214/22; C09D 7/20;
C09D 11/106; C09D 11/108; C09D 127/16;
H10N 30/098**                                   (Cont.)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ARKEMA FRANCE
92700 Colombes (FR)**

(72) Inventors:
• **SEKINE, Tomohito
YONEZAWA, 992-0048 (JP)**
• **TOKITO, Shizuo
YONEZAWA, 992-0026 (JP)**

(74) Representative: **Arkema Patent
Arkema France
DRD-DPI
420, rue d'Estienne d'Orves
92705 Colombes Cedex (FR)**

(54) **COMPOSITION FOR ENHANCING ELECTROACTIVE PROPERTIES OF A FLUORINATED POLYMER**

(57)     The present application deals with a composition comprising: a fluorinated polymer comprising repeating units derived from vinylidene fluoride and trifluoroethylene, the fluorinated polymer having a melt flow index as measured according to ASTM D1238-20 at 230°C under a load of 10 kg of: 6 g/10 min to 16 g/10 min, and a liquid vehicle having Hansen solubility parameters ($\delta_d$ ; $\delta_\rho$; $\delta_h$) so that (Ra)$^2 \leq 22$, wherein Ra is defined by the following equation:

$$Ra^2 = 4 \cdot (\delta_d - 17{,}1)^2 + (\delta_p - 12{,}6)^2 + (\delta_h - 10{,}6)^2 \ (eq.\,1).$$

(52) Cooperative Patent Classification (CPC): (Cont.)

C-Sets
**C08F 214/22, C08F 214/182**

**Description**

TECHNICAL FIELD

The present application relates to an electroactive polymer in a liquid vehicle, often referred to as an electroactive polymer ink.

More specifically the application deals with a composition comprising a copolymer comprising repeating units derived from vinylidene fluoride and trifluoroethylene in a liquid vehicle.

The composition may be used to form a polymeric layer, often referred to as a coating or a film, having enhanced electroactive properties, which may be of particular interest in electronic devices.

TECHNICAL BACKGROUND & GOALS OF THE INVENTION

Ferroelectric materials are a class of crystalline or semi crystalline materials that exhibit an hysteresis of the Polarization-Electric field curve. These materials possess a phase transition at the Curie temperature between the ferroelectric and the paraelectric phase.

At a given temperature below the Curie transition, the polarization hysteresis curve is characterized by the coercitive field (Ec) (absolute value of the electric field when polarization is zero) and remnant polarization (Pr) (absolute value of polarization when applied electric field is zero)

Piezoelectricity is the ability of some materials to convert mechanical energy into electrical energy and vice-versa. When a piezoelectric material is subjected to a mechanical input (deformation, force, vibration...), a charge or a voltage is generated at the surface of the material (direct piezoelectric effect). Direct piezoelectric effect of ferroelectric material is due to the variation of polarization induced by the mechanical solicitation.

Due to their Ferroelectric structure and their piezoelectric properties, P(VDF-TrFE) are base materials for electronic devices, for example printed sensors to measure pressure, force, deformation, acoustic vibration etc.

The scientific publication by Ohigashi, H., & Hattori, T. (1995). Improvement of piezoelectric properties of poly (vinylidene fluoride) and its copolymers by crystallization under high pressures. Ferroelectrics, 171(1), 11-32, generally teaches that the piezoelectric activity of an electroactive polymer is proportional to its remnant polarization, which is again proportional to its crystallinity (see first paragraph on page 12).

It is also known from Nguyen, Q. D., Venkatesan, T. R., Wirges, W., & Gerhard, R. (2019, July). Non-uniform polarization profiles in P (VDF-TrFE) copolymer films after cyclical poling. In 2019 IEEE International Symposium on Applications of Ferroelectrics (ISAF) (pp. 1-4). IEEE, that a commercial film of P(VDF-TrFE) copolymer having a molar ratio VDF:TrFE of 75:25 has a measured remanent polarization of 70 mC/m$^2$ (meaning: 7,0 $\mu$C/m$^2$) when poled at a field of 100 MV/m.

Ohigashi studies the effect of crystallization at high pressure on the properties of ferroelectric polymers. It notably shows that crystallizing some P(VDF-TrFE) copolymers at a very high pressure, typically several hundreds or even a few thousands of bars, may be beneficial to enhance its piezoelectric activity. However interesting that method may be, being able to reach for example for a P(VDF-TrFE) copolymer having a molar ratio VDF:TrFE of 75:25, a remanent polarization as high as 95 mC/m$^2$ (see Table 1 ; electric field for poling not mentioned), it is very difficult in practice to carry out and not practicable at all at an industrial scale.

There exists presently a need to produce one or more polymeric layers, notably films or coatings, of a fluorinated polymer comprising repeating units derived from vinylidene fluoride and trifluoroethylene with enhanced electroactive properties, notably with higher remanent polarization, also noted Pr.

The invention aims at providing compositions adapted to manufacture such polymeric layers and the polymeric layers thereof.

SUMMARY OF THE INVENTION

It is a first object of the invention to cover a composition comprising a fluorinated polymer and a liquid vehicle.

The fluorinated polymer comprises repeating units derived from vinylidene fluoride and trifluoroethylene, the fluorinated polymer having a melt flow index as measured according to ASTM D1238-20 at 230°C under a load of 10 kg of 6 g/10 min to 16 g/10 min.

The liquid vehicle has Hansen solubility parameters ($\delta_d$ ; $\delta_\rho$ ; $\delta_h$) so that (Ra)$^2$ ≤ 22, wherein Ra is defined by the following equation:

$$Ra^2 = 4 \cdot (\delta_d - 17,1)^2 + (\delta_p - 12,6)^2 + (\delta_h - 10,6)^2 \ (eq.\,1).$$

Preferably, the fluorinated polymer has a melt flow index as measured according to ASTM D1238-20 at 230°C under a load of 10 kg of 8 g/10 min to 15 g/ 10 min, and more preferably of 10 g/10 min to 14 g/10 min.

In some specific embodiments, the fluorinated polymer has a melt flow index of 11 g/10min to 13 g/10min, as measured according to ASTM D1238-20 at 230°C under a load of 10 kg.

In some embodiments, the fluorinated polymer also comprises one or more repeating units derived from a fluorinated monomer of formula (I):

$$CX_1X_2 = CX_3Z- \qquad \text{(I)}$$

wherein each of the $X_1$, $X_2$ and $X_3$ is independently chosen from H, F and alkyl groups comprising from 1 to 3 carbon atoms which are optionally partially or totally fluorinated, and in which Z is chosen from Cl, Br and I.

In some preferential embodiment wherein the fluorinated polymer contains one or more repeating units derived from a fluorinated monomer of formula (I), such repeating unit(s) is advantageously chlorotrifluoroethylene, a chlorofluoroethylene, or mixtures thereof.

The inventors have surprisingly found that the combination of: a) a selection of a very specific range of melt flow indexes for the fluorinated polymer together with: b) a selection of a liquid vehicle having Hansen solubility parameters $(\delta_d, \delta_\rho, \delta_H)$ such that the distance, calculated as being "Ra", to a center having coordinates (17,1; 12,6; 10,6) is sufficiently low; enabled to obtain a fluorinated polymeric layer, as for instance a coating or a film, having enhanced electroactive properties, notably having a higher remanent polarization.

In some embodiments, the fluorinated polymer essentially consists, or consists of: repeating units derived from vinilydene fluoride, trifluoroethylene, and optionally one or several fluorinated monomers of formula (I), wherein the molar ratio of trifluoroethylene is of 15 % to 50%, preferentially of 16% to 35%, and most preferentially of 17% to 32%, compared to the total amount of moles of vinylidene fluoride and trifluoroethylene repeating units in the polymer. The molar proportion of the repeating units derived from the one or several fluorinated monomers of formula (I) is from 0 % to 15%, and preferentially from 1 to 10%, relative to the total amount of moles of all the repeating units in the polymer.

In some embodiments, the liquid vehicle has Hansen solubility parameters so that $(Ra)^2 \leq 15$, preferentially so that $(Ra)^2 \leq 8$, preferentially so that $(Ra)^2 \leq 6$, preferentially so that $(Ra)^2 \leq 4$, and most preferentially so that $(Ra)^2 \leq 3$.

In some embodiments, the liquid vehicle essentially consists of, or consists of: dimethyl sulfoxide, tetramethyl urea, diethylene glycol monoethyl ether, N-ethyl-2-pyrrolidone, N-methyl-2-pyrrolidone, trimethyl phosphate, triethyl phosphate, dimethyl formamide, dimethyl acetamide, and mixtures thereof.

Preferentially, the liquid vehicle essentially consists of, or consists of, N-methyl-2-pyrrolidone, trimethyl phosphate, triethyl phosphate, dimethyl formamide, dimethyl acetamide, and mixtures thereof.

More preferentially, the liquid vehicle essentially consists of, or consists of: triethyl phosphate, dimethyl formamide, dimethyl acetamide, and mixtures thereof.

In some specific embodiments, the liquid vehicle essentially consists of, or consists of: dimethyl formamide, dimethyl acetamide, and mixtures thereof.

In some embodiments, the mass concentration of the fluorinated polymer in the liquid vehicle is of 0.1% to 50%, preferably of 1% to 30%, and most preferably of 5% to 20%.

The invention also relates to a polymeric layer obtained by a process comprising a step of deposition of a composition according to the invention, the step of deposition comprising a removal of the liquid vehicle from the composition.

In some embodiments, the step of deposition is carried out by one of the techniques chosen among the group consisting of: spin coating, spray coating, bar coating, slot-die coating, dip coating, roll-to-roll printing, screen-printing, flexographic printing, lithographic printing, ink-jet printing; and preferably spin coating.

In some embodiments, the polymeric layer has an average thickness of 100 nm to 100 $\mu$m, preferably of 500 nm to 50 $\mu$m, more preferably of 750 nm to 20 $\mu$m, and most preferably of 1 $\mu$m to 10 $\mu$m.

In some embodiments, the process comprises a step of annealing the fluorinated polymer at a temperature lower than its melt temperature.

In some embodiments, the process comprises a step of poling.

The invention finally relates to an electronic device comprising a polymeric layer according to the invention. The electronic device is preferably chosen among field effect transistors, memory devices, capacitors, sensors, actuators, microelectromechanical systems, wearable electric devices market, robotic sensors and haptic devices.

DETAILED DESCRIPTION OF THE INVENTION

The invention will now be described in more detail without limitation in the following description.

In the description of the invention the term "a" or "an" means "at least one". Thus a composition comprising a fluorinated polymer and a liquid vehicle means a solution comprising at least one fluorinated polymer and at least one liquid vehicle. The expression "polymer essentially consisting of repeating units" means that it comprises at least 99%molar, or at least 99.5%molar by mole, or at least 99.9%molar of these units with respect to the total number of moles of the units constituting the polymer.

The Melt Flow Index of the polymer, abbreviated MFI, is measured according to ASTM D1238-20 at 230°C under a load of 10 kg. It is expressed in grams per ten minutes (g/ 10 min).

The melt temperature of the polymer corresponds to the peak temperature on second heat, as measured by differential scanning calorimetry (DSC) analysis according to the ASTM D3418-15, using ramps at 10°C/min. The Curie transition temperature of the polymer, which is a first-order transition, may be measured in the same conditions as the melt temperature.

In the description, appropriate solvents are selected thanks to their Hansen solubility parameters ($\delta_d$ ; $\delta_\rho$ ; $\delta_h$). Hansen solubility parameters were developed by Charles M. Hansen since 1967 as a way of predicting if one material would dissolve in another and form a solution. Parameter "$\delta_d$" is related to the energy from dispersion forces between molecules. Parameter "$\delta_p$" is related to the energy from dipolar intermolecular force between molecules. Parameter "$\delta_h$" is related to the energy from hydrogen bonds between molecules. Hansen solubility parameters are expressed in $\text{MPa}^{(1/2)}$.

Hansen solubility parameters ($\delta_d$ ; $\delta_p$; $\delta_h$) have been assessed for a long time for the most commonly used solvents and are now gathered in data tables. The Hansen solubility parameters of the different liquid vehicles herein referred to were obtained from: C. M. (2007). Hansen solubility parameters: a user's handbook. CRC press. Other publications and/or data tables may be used in case the Hansen solubility parameters are not found for one liquid vehicle in the aforementioned handbook. One may cite for example: CRC Handbook of Solubility Parameters and Other Cohesion Parameters by Allan F. M. Barton. CRC Press (1983) or: CRC Handbook of Solubility Parameters and Other Cohesion Parameters, par Allan F.M. Barton, 2nd edition (1991).

The remanent polarization was measured at 20°C at an electric field of 100 MV/m using the Sawyer Tower methods (LC2, from Radiant Tech. Co.).

**Fluorinated polymer**

The fluorinated polymer comprises repeating units derived from vinylidene fluoride (abbreviated as VDF or VF2) and trifluoroethylene (abbreviated as TrFE or VF3). The fluorinated polymer may notably comprise a molar ratio of at least 50%, or at least 75%, or at least 80%, or at least 85% of repeating units derived from vinylidene fluoride and trifluoroethylene relative to the total amount of moles of all the repeating units in the polymer.

The fluorinated polymer may comprise other repeating unit(s) than the one derived from vinylidene fluoride and trifluoroethylene. In particular, the other repeating unit(s) may be derived from a fluorinated monomer of formula (I):

$$CX_1X_2=CX_3Z- \qquad (I)$$

wherein each of the $X_1$, $X_2$ and $X_3$ is independently chosen from H, F and alkyl groups comprising from 1 to 3 carbon atoms which are optionally partially or totally fluorinated, and in which Z is chosen from Cl, Br and I.

The fluorinated polymer may notably comprise one repeating unit derived from chlorotrifluoroethylene (CTFE), a chlorofluoroethylene and particularly1,1-chlorofluoroethylene (CFE), or a mixture thereof.

In some embodiments, the fluorinated polymer may essentially consist of, or consist of, repeating units derived from vinylidene fluoride, trifluoroethylene and optionally one or several units derived from a fluorinated monomer of formula (I).

The fluorinated polymer may in specific embodiments be P(VDF-TrFE), P(VDF-TrFE-CTFE) or P(VDF-TrFE-CFE).

In preferential embodiments, the molar ratio of trifluoroethylene repeating units is of 15 % to 50%, preferentially of 16% to 35%, and most preferentially of 17% to 32%, relative to the total amount of moles of vinylidene fluoride and trifluoroethylene repeating units. Indeed, the fluorinated polymer has particularly advantageous ferroelectric properties over these ranges.

In preferential embodiments, the fluorinated polymer may essentially consist of, or consist of, repeating units derived from vinylidene fluoride, trifluoroethylene and optionnally one or several repeating units derived from a fluorinated monomer of formula (I), wherein the molar ratio of trifluoroethylene repeating units is of 15 % to 50%, preferentially of 16% to 35%, and most preferentially of 17% to 32%, relative to the total amount of moles of vinylidene fluoride and trifluoroethylene repeating units, and wherein the molar ratio of the one or several fluorinated monomers of formula (I) is of 0 to 15%, and preferentially of 1 to 10%, relative to the total amount of moles of all the repeating units in the polymer.

In some specific embodiments, the fluorinated polymer may essentially consist of, or consist of, repeating units derived from vinylidene fluoride and trifluoroethylene, wherein the molar ratio of trifluoroethylene repeating units is of 17 % to 32%, relative to the total amount of moles of vinylidene fluoride and trifluoroethylene repeating units. The molar ratio of trifluoroethylene repeating units may notably be of 17 % to 23%, or of 23% to 28%, or of 28% to 32%, relative to the total amount of moles of vinylidene fluoride and trifluoroethylene repeating units.

The melt flow index as measured according to ASTM D1238-20 at 230°C under a load of 10 kg is of: 6 g/10 min to 16 g/10 min.

The melt flow index may be of 6g/10min or greater, of 7g/10min or greater, of 8g/10min or greater, of 9g/10min or greater, of 10g/10min or greater, or of 11g/10min or greater.

The melt flow index may be of 16g/10min or lower, of 15g/10min or lower, of 14g/10min or lower, of 13g/10min or lower, or of 12g/10min or lower.

The melt flow index may notably be of 8 g/10 min to 15 g/ 10 min, and preferably of 10 g/10 min to 14 g/10 min.

In specific embodiments, the melt flow index of the fluorinated polymer is of 11g/10 min to 13 g/10 min.

The fluorinated polymer may be produced by methods known per se, such as emulsion polymerization, suspension polymerization and solution polymerization. The fluorinated polymer may advantageously be produced by suspension polymerization and more particularly preferably carried out in water.

In this embodiment, it is advantageous to add a suspension agent to the reaction medium. Use may especially be made of a cellulose derivative, in particular a cellulose ether such as methyl cellulose, ethylhydroxyethylcellulose, or hydroxypropylmethylcellulose.

The reaction may be initiated by adding a radical polymerization initiator, which may especially be an organic peroxide such as a peroxydicarbonate.

Moreover, it is advantageous to add an agent which regulates the chain length to the reaction medium. Use may especially be made of ethyl acetate or diethyl carbonate or an alcohol such as isopropanol, for example.

### Liquid vehicle

Compatibility of the liquid vehicle with the fluorinated polymer can be characterized thanks to the Hansen solubility parameters of the liquid vehicle and of the fluorinated polymer.

For polymers comprising repeating units derived from vinylidene fluoride and trifluoroethylene, such as the ones used in the present invention, it has generally been assumed in the Art that the Hansen solubility parameters of the homopolymer of vinylidene fluoride could be used as a fair approximation.

The inventors have particularly found that the assessment made by MA, Jing et LARSEN, Raino Mikael. Comparative study on dispersion and interfacial properties of single walled carbon nanotube/polymer composites using Hansen solubility parameters. ACS applied materials & interfaces, 2013, vol. 5, no 4, p. 1287-1293, suited particularly well for the selection of a liquid vehicle in order to carry out the invention, and to obtain enhanced electroactive properties for a polymeric layer obtained from a composition according to the invention.

MA calculated Hansen solubility parameters for the homopolymer of vinylidene fluoride being of (17,1 ; 12,6 ; 10,6).

The distance (Ra) between the Hansen solubility parameters between the liquid vehicle ($\delta_d$ ; $\delta_p$ ; $\delta_h$) and the point of coordinates (17,1 ; 12,6 ; 10,6) defines equation 1 below:

$$Ra^2 = 4 \cdot (\delta_d - 17,1)^2 + (\delta_p - 12,6)^2 + (\delta_h - 10,6)^2 \; (eq.\,1).$$

According to the invention, the liquid vehicle has Hansen solubility parameters ($\delta_d$ ; $\delta_p$ ; $\delta_h$) so that $(Ra)^2 \leq 22$, preferentially so that $(Ra)^2 \leq 8$, more preferentially so that $(Ra)^2 \leq 6$, even more preferentially so that $(Ra)^2 \leq 4$, and most preferentially so that $(Ra)^2 \leq 3$.

According to some embodiments, the liquid vehicle comprises, essentially consists of, or consists of: dimethyl sulfoxide, tetramethyl urea, diethylene glycol monoethyl ether, N-ethyl-2-pyrrolidone, N-methyl-2-pyrrolidone, trimethyl phosphate, triethyl phosphate, dimethyl formamide, dimethyl acetamide, and mixtures thereof.

Preferentially, the liquid vehicle comprises, essentially consists of, or consists of: N-methyl-2-pyrrolidone, trimethyl phosphate, triethyl phosphate, dimethyl formamide, dimethyl acetamide, and mixtures thereof.

Even more preferentially, the liquid vehicle comprises essentially consists of, or consists of: triethyl phosphate, dimethyl formamide, dimethyl acetamide, and mixtures thereof.

Most preferentially, the liquid vehicle comprises, essentially consists of, or consists of: dimethyl formamide, dimethyl acetamide, and mixtures thereof.

### Composition

The composition comprises, essentially consists of, or consists of: one or several fluorinated polymers selected as described above and one or more liquid vehicles selected as described above.

The thickness of the polymeric layer which can be obtained by deposition of the composition according to the invention and removal of the liquid vehicle strongly depends on the mass concentration of the fluorinated polymer in the liquid vehicle. If the dry content of the formulation is too low, one will have to process several printing steps to achieve sufficient layer thickness.

The mass concentration of the fluorinated polymer in the liquid vehicle may therefore be of 0.1% or greater, preferably of 1% or greater, and most preferably of 5% or greater.

The mass concentration of the fluorinated polymer in the liquid vehicle may generally be of 50% or less, preferably of 30% or less and most preferably of 20% or less.

In some embodiments, the mass concentration of the fluorinated polymer in the liquid vehicle is of 0.1% to 50%, preferably of 1% to 30%, and most preferably of 5% to 20%. The mass concentration of the fluorinated polymer in the liquid vehicle may notably be of 5% to 9%, or of 9% to 15%, or of 15% to 20%.

The composition may optionally comprise one or more additives, for instance selected from surfactants, rheology modifiers, ageing resistance agents, pigments or dyes, fillers (including nanofillers), or any residual additives used for synthesizing the fluoropolymer.

In some embodiments, the composition may essentially consists of, or consists of: one or several fluorinated polymers selected as described above, one or more liquid vehicles selected as described above, and optionally one or more of such additives.

## Polymeric layer made from the composition

As shown in the examples, the composition according to the invention enables to manufacture polymeric layers with enhanced electroactive properties, notably with a higher remanent polarization than what was known until now.

A polymeric layer, notably a film or a coating, may be manufactured by deposition of the composition according to the invention on a substrate surface. The deposition comprises the removal, notably by evaporation, of the liquid vehicle of the composition.

The substrate surface may be made for example a glass surface or a silicon surface or a polymer surface or a metal surface.

Deposition methods known in the art are notably spin coating, spray coating, bar coating, slot-die coating, dip coating, roll-to-roll printing, screen-printing, flexographic printing, lithographic printing, and ink-jet printing.

In some embodiments, as in the examples below, the deposition method may be spin coating.

The polymeric layer obtained by one of the aforementioned deposition method, for example spin coating may have an average thickness of 100 nm to 100 $\mu$m, preferably of 500 nm to 50 $\mu$m, more preferably of 750 nm to 20 $\mu$m, and most preferably of 1 $\mu$m to 10 $\mu$m. The average polymeric layer may notably be of 1 $\mu$m to 3 $\mu$m, or of 3 $\mu$m to 6 $\mu$m, or of 6 $\mu$m to 10 $\mu$m.

In order to increase ferroelectric crystallinity, an annealing step may be carried out on the obtained polymeric layer. The annealing step is usually carried out above the Curie temperature and below the melting temperature of the fluorinated ferroelectric polymer according to the invention. The annealing may notably be performed by subjecting the deposited layer to a temperature of from 50 to 200°C, preferably from 80 to 180°C, more preferably from 100 to 160°C, notably from 120 to 150°C.

The polymeric layer may be poled as such or already integrated in an electronic device. It is well known that the higher the poling electric field, the higher the orientation of the dipole perpendicular to the film direction and then the higher the remant polarization. However, the higher the poling field the higher the risk of break-down during poling. One has then to limit the applied electric field during poling to ensure fabrication yield. Generally, one take a limited poling field above the coercitive field of ferroelectric copolymer (ie 50V/$\mu$m) in the range of 75 to 150 V/$\mu$m, and preferably around 100V/$\mu$m.

## Electronic devices

The polymeric layer according to the invention can be used as a layer in an electronic device, for example a sensor.

The sensitivity of a sensor containing a polymeric layer of a ferroelectric material is directly related to the remnant polarization of the material therof. Therefore, the present invention enables to manufacture sensors with higher sensitivity. More generally speaking, the polymeric layer according to the invention enables to manufacture electronic devices with enhanced properties.

By electronic device is meant either a single electronic component, or a set of electronic components, capable of fulfilling one or more functions in an electronic circuit.

In order to build one electronic component, additional layers to the polymeric layer of the invention may be deposited on a substrate, for example one or more layers of polymers, semiconductor materials, or metals, in a manner known per se, to make

According to certain variations, the electronic device is more particularly an optoelectronic device, that is to say capable of emitting, detecting or controlling electromagnetic radiation.

Examples of electronic devices, or where appropriate optoelectronic, concerned by the present invention are transistors (in particular field effect), chips, batteries, photovoltaic cells, light-emitting diodes (LEDs), organic light-emitting diodes (OLED), sensors, actuators, transformers, haptic devices, microelectromechanical systems, electro-caloric devices and detectors.

According to a preferred variant, the polymeric layer according to the invention may be used in a sensor, in particular a piezoelectric sensor, as an active layer between two metal or polymer electrodes. The sensor may be notably be a force, apressure, avibration, or an ultrasound sensor.

Electronic and optoelectronic devices are used and integrated in many devices, equipment or electronic subassemblies and in many objects and applications such as televisions, mobile phones, rigid or flexible screens, thin film photovoltaic modules, lighting sources, energy sensors and converters, etc.

## Exemples

### Production of P(VDF-TrFE) with different melt flow indexes

Four P(VDF-TrFE) (P1, P2, P3, P4) having a molar ratio VDF:TrFE of 75:25 and a different melt flow index were prepared by suspension polymerization by reacting trifluoroethylene(TrFE), vinylidene fluoride (VDF) in deionized water, using methylhydroxypropyl cellulose as a dispersant, propyle peroxydicarbonate as initiator and different weight. Different proportions of ethyl acetate, used as a transfer agent, were added in order to adjust the polymer melt flow index.

The chemical composition of the polymer was analyzed by 1 H NMR.

The melt peak temperature (Tm) was measured on second heat using temperature ramps at 10°C/min.

The Melt Flow Index (MFI) was measured at 230°C under a load of 10kg according to ASTM D1238-20 on a Flowmeter D4059 B, commercialized by Dynisco company.

These properties of the four synthetized polymers are gathered in Table 1 below:

Table 1

| Sample | % mol TrFE | % mol VDF | Tm (°C) | MFI (g) |
|---|---|---|---|---|
| P1 | 0.262 | 0.738 | 149 | 33 |
| P2 | 0.257 | 0.743 | 149 | 11,5 |
| P3 | 0.253 | 0.747 | 150 | 2,86 |
| P4 | 0.249 | 0.751 | 151 | 2,64 |

### Film and sensor manufacturing

In order to process through printing technologies a sensor based on P(VDf-TrFE) copolymer, 0.5 mL of a polyvinylpyrrolidone(PVP)-Melanine solution, with a PVP:melamine weight ratio of 1:1 (Sigma Aldrich Co., Ltd.), was spin-coated (2000 rpm, 1 min) onto a Polyethylene Naphthalate (PEN) substrate ((Panac Co., Ltd.) in ambient air at 23°C to form a flat PVP layer followed by annealing at 150 °C for 1 h. The thickness of the PVP layer was 800 nm.

Next, this layer was treated with an oxygen plasma cleaning system (RIE-PC300, SAMCO Co., Ltd.) for 60 s to control the surface energy of the PVP layer. The radio-frequency (RF) power of the plasma and the $O_2$ flow rate were set to 100 W and 30 seem, respectively. An upper and a lower Au electrodes were both thermally deposited to a thickness of 30 nm. Next, 0.5 mL of 12% weight P(VDF-TrFE) solutions and different solvents [a) N,N-dimethylformamide (DMF, Sigma Aldrich Co., Ltd.), b) trimethyl phosphate (Trimethylphosphate(TMP), Kanto Chemical Co., Ltd.), c) isophorone (IPN, Sigma Aldrich Co., Ltd.), and d) cyclopentanone (CPN, Sigma Aldrich Co., Ltd.)] were separately spin-coated onto the surfaces in ambient air at 23°C to construct the ferroelectric layer with a thickness of 1.5 $\mu$m (from 800 to 3000 rpm, 1 min). Next, annealing was performed at 135 °C for 1 h.

Finally, to form a passivation layer with a thickness of 800 nm, 0.5 mL of PVP solution was spin-coated (2000 rpm, 1 min) onto this assembly in ambient air, followed by annealing at 135 °C for 1 h.

Table 2 below presents the Hansen solubility parameters of the four different solvents which were used and the value of (Ra)[2] calculated according to equation 1:

Table 2

| Solvent | $\delta_d$ | $\delta_p$ | $\delta_h$ | $Ra^2$ |
|---------|-----------|-----------|-----------|--------|
| CPN | 17,9 | 11,9 | 5,2 | 32,21 |
| IPN | 16,6 | 8,2 | 7,4 | 30,60 |
| TMP | 16,7 | 15,9 | 10,2 | 11,69 |
| DMF | 17,4 | 13,7 | 11,3 | 2,06 |

Remnant polarization was measured at 20°C at 100V/μm using the Sawyer Tower methods.

For each one of the examples, fifteen devices have been produced and characterized. The remnant polarization indicated in Table 3 below represents the average of the remanent polarizations measured on the 15 devices.

Table 3

| Example | Solvent | Polymer | MFI | $Ra^2$ | Pr ($\mu C/cm^2$) |
|---------|---------|---------|-----|--------|-------------------|
| 1 Comparative | CPN | P2 | 11,5 | 32,21 | 7,45 |
| 2 Comparative | IPN | P2 | 11,5 | 30,60 | 7,80 |
| 3 Invention | TMP | P2 | 11,5 | 11,69 | 8,00 |
| 4 Comparative | DMF | P1 | 58 | 2,06 | 7,23 |
| 5 Invention | DMF | P2 | 11,5 | 2,06 | 8,30 |
| 6 Invention | DMF | P3 | 2,86 | 2,06 | 7,93 |
| 7 invention | DMF | P4 | 2.64 | 2,06 | 7,97 |

As shown by table 3 the combination of a selection on melt flow index and a solvent through his Hansen solubility parameters and therefore its calculated $(Ra)^2$ value enable to obtain an improved remanent polarization, greater than 7,8 pC/cm$^2$ for a P(VDF-TrFE) copolymer having a molar ratio VDF:TrFE of 75:25.

**Claims**

1.  Composition comprising:

    - a fluorinated polymer comprising repeating units derived from vinylidene fluoride and trifluoroethylene, the fluorinated polymer having a melt flow index as measured according to ASTM D1238-20 at 230°C under a load of 10 kg of: 6 g/10 min to 16 g/10 min, preferably of 8 g/10 min to 15 g/ 10 min, and more preferably of 10 g/10 min to 14 g/10 min;
    - a liquid vehicle having Hansen solubility parameters ($\delta_d$ ; $\delta_p$ ; $\delta_h$) so that $(Ra)^2 \leq 22$, wherein Ra is defined by the following equation:

$$Ra^2 = 4 \cdot (\delta_d - 17{,}1)^2 + (\delta_p - 12{,}6)^2 + (\delta_h - 10{,}6)^2 \ (eq.\,1).$$

2.  Composition according to claim 1, wherein the fluorinated polymer also comprises one or more repeating units derived from a fluorinated monomer of formula (I):

    $$CX_1X_2{=}CX_3Z{-} \qquad (I)$$

    wherein each of the $X_1$, $X_2$ and $X_3$ is independently chosen from H, F and alkyl groups comprising from 1 to 3 carbon atoms which are optionally partially or totally fluorinated, and in which Z is chosen from Cl, Br and I; and preferably the fluorinated monomer of formula (I) is chlorotrifluoroethylene, a chlorofluoroethylene, or mixtures thereof.

3.  Composition according to any one of claims 1 and 2, wherein the fluorinated polymer essentially consists, or consists of: repeating units derived from vinilydene fluoride, trifluoroethylene, and optionally one or several fluorinated monomers of formula (I), wherein the molar ratio of trifluoroethylene repeating units is of 15 % to 50%, preferentially of 16% to 35%, and most preferentially of 17% to 32%, relative to the total amount of moles of vinylidene fluoride and trifluoroethylene repeating units in the polymer; and,

wherein the molar ratio of the one or several fluorinated monomers of formula (I) is of 0% to 15%, and preferentially of 1% to 10%, relative to the total amount of moles of all the repeating units in the polymer.

4. Composition according to any one of the preceding claims, wherein the liquid vehicle has Hansen solubility parameters so that $(Ra)^2 \leq 15$, preferentially so that $(Ra)^2 \leq 8$, preferentially so that $(Ra)^2 \leq 6$, preferentially so that $(Ra)^2 \leq 4$, and most preferentially so that $(Ra)^2 \leq 3$.

5. Composition according to any one of the preceding claims, wherein the liquid vehicle essentially consists of, or consists of:

   dimethyl sulfoxide, tetramethyl urea, diethylene glycol monoethyl ether, N-ethyl-2-pyrrolidone, N-methyl-2-pyrrolidone, trimethyl phosphate, triethyl phosphate, dimethyl formamide, dimethyl acetamide, and mixtures thereof ;
   preferentially N-methyl-2-pyrrolidone, trimethyl phosphate, triethyl phosphate, dimethyl formamide, dimethyl acetamide, and mixtures thereof ;
   more preferentially triethyl phosphate, dimethyl formamide, dimethyl acetamide,and mixtures thereof; and,
   most preferentially dimethyl formamide, dimethyl acetamide, and mixtures thereof.

6. Composition according to any one of the preceding claims, wherein the fluorinated polymer has a melt flow index of 11 g/10min to 13 g/10min, as measured according to ASTM D1238-20 at 230°C under a load of 10 kg.

7. Composition according to any one of the preceding claims, wherein the mass concentration of the fluorinated polymer in the liquid vehicle is of 0.1 to 50%, preferably of 1% to 30%, and most preferably of 5% to 20%.

8. Polymeric layer obtained by a process comprising a step of deposition of a composition according to any one of claims 1 to 7, the step of deposition comprising a removal of the liquid vehicle from the composition.

9. Polymeric layer according to claim 8, wherein the step of deposition is carried out by one of the techniques chosen among the group consisting of: spin coating, spray coating, bar coating, slot-die coating, dip coating, roll-to-roll printing, screen-printing, flexographic printing, lithographic printing, ink-jet printing; and preferably spin coating.

10. Polymeric layer, notably film, according to any one of claims 8 and 9, having an average thickness of 100 nm to 100 $\mu$m, preferably of 500 nm to 50 $\mu$m, more preferably of 750 nm to 20 $\mu$m, and most preferably of 1 $\mu$m to 10 $\mu$m.

11. Polymeric layer according to any one of claims 8 to 10, wherein the process comprises a step of annealing the fluorinated polymer at a temperature lower than its melt temperature.

12. Polymeric layer according to any one of claims 8 to 11, wherein the process comprises a step of poling.

13. Electronic device comprising a polymeric layer according to any one of claims 8 to 12, the electronic device being preferably chosen among field effect transistors, memory devices, capacitors, sensors, actuators, microelectromechanical systems, wearable electric devices, robotic sensors and haptic devices.

Europäisches
Patentamt

European
Patent Office

Office européen
des brevets

# EUROPEAN SEARCH REPORT

Application Number

EP 22 15 4643

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/131862 A1 (SZMANDA CHARLES R [US] ET AL) 8 July 2004 (2004-07-08) | 1-13 | INV. C09D127/08 |
| Y | * examples; tables * | 1-13 | C09D127/16 C09D7/20 |
| Y | US 2021/376329 A1 (PLEE DOMINIQUE [FR] ET AL) 2 December 2021 (2021-12-02) * paragraph [0067] * * examples * | 1-13 | C08L27/16 H01L41/45 |

TECHNICAL FIELDS
SEARCHED      (IPC)

C09D
C08F
C09J
C09G
C08L
H02N
H01L

The present search report has been drawn up for all claims

| Place of search | Date of completion of the search | Examiner |
|---|---|---|
| The Hague | 1 July 2022 | Parry, Julian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................
& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 22 15 4643

This annex lists the patent family members relating to the patent documents cited in the above-mentioned European search report.
The members are as contained in the European Patent Office EDP file on
The European Patent Office is in no way liable for these particulars which are merely given for the purpose of information.

01-07-2022

| Patent document cited in search report | | Publication date | Patent family member(s) | | Publication date |
|---|---|---|---|---|---|
| US 2004131862 | A1 | 08-07-2004 | NONE | | |
| US 2021376329 | A1 | 02-12-2021 | CN | 112640159 A | 09-04-2021 |
| | | | EP | 3830887 A1 | 09-06-2021 |
| | | | FR | 3084528 A1 | 31-01-2020 |
| | | | JP | 2021533529 A | 02-12-2021 |
| | | | KR | 20210034075 A | 29-03-2021 |
| | | | TW | 202034566 A | 16-09-2020 |
| | | | US | 2021376329 A1 | 02-12-2021 |
| | | | WO | 2020021204 A1 | 30-01-2020 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **OHIGASHI, H. ; HATTORI, T.** Improvement of piezoelectric properties of poly (vinylidene fluoride) and its copolymers by crystallization under high pressures. *Ferroelectrics,* 1995, vol. 171 (1), 11-32
- **NGUYEN, Q. D. ; VENKATESAN, T. R. ; WIRGES, W. ; GERHARD, R.** Non-uniform polarization profiles in P (VDF-TrFE) copolymer films after cyclical poling. *2019 IEEE International Symposium on Applications of Ferroelectrics (ISAF),* July 2019, 1-4
- **C. M.** Hansen solubility parameters: a user's handbook. CRC press, 2007
- **ALLAN F. M. BARTON.** CRC Handbook of Solubility Parameters and Other Cohesion Parameters. CRC Press, 1983
- **ALLAN F.M. BARTON.** CRC Handbook of Solubility Parameters and Other Cohesion Parameters. 1991
- **MA, JING ; LARSEN, RAINO MIKAEL.** Comparative study on dispersion and interfacial properties of single walled carbon nanotube/polymer composites using Hansen solubility parameters. *ACS applied materials & interfaces,* 2013, vol. 5 (4), 1287-1293